Europäisches Patentamt

European Patent Office

Office européen des brevets

(11) Publication number: **0 067 683**
**B1**

(12) **EUROPEAN PATENT SPECIFICATION**

(45) Date of publication of patent specification: **20.08.86**

(51) Int. Cl.⁴: **G 01 R 15/07, G 01 R 29/12**

(21) Application number: **82303031.7**

(22) Date of filing: **11.06.82**

(54) **Electric field detector.**

| | |
|---|---|
| (30) Priority: **12.06.81 JP 90537/81** <br> **15.06.81 JP 91914/81** | (73) Proprietor: **Kabushiki Kaisha Meidensha** <br> **1-17, Ohsaki 2-chome** <br> **Shinagawa-ku Tokyo 141 (JP)** |
| (43) Date of publication of application: <br> **22.12.82 Bulletin 82/51** | (72) Inventor: **Yasudsa, Tomio** <br> **20-13, Chuo 3-chome Kasukabe-shi** <br> **Saitama-ken (JP)** <br> Inventor: **Ichiyama, Toshiyuki** <br> **32-9, Higashimine-machi** <br> **Ohta-ku Tokyo (JP)** |
| (45) Publication of the grant of the patent: <br> **20.08.86 Bulletin 86/34** | |
| (84) Designated Contracting States: <br> **CH DE FR GB IT LI NL SE** | (74) Representative: **Nettleton, John Victor et al** <br> **Abel & Imray Northumberland House 303-306** <br> **High Holborn** <br> **London, WC1V 7LH (GB)** |
| (56) References cited: <br> **EP-A-0 036 760** <br> **DE-A-2 510 545** <br> **DE-A-2 516 619** <br> **DE-A-2 903 838** <br> **DE-B-1 283 363** <br> **DE-B-2 341 074** <br> **GB-A-2 068 137** <br> **US-A-4 010 632** | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to an electric field detector and, more particularly is concerned with an electric field detector using a photoelectric connecting element for converting optical energy to electrical energy.

In recent years, various kinds of electric field detector have been put into practical use. In particular, photoelectric converting elements are widely used in electric field detectors. Electric field detectors of this kind can be used in various monitoring devices and the like. The present applicant has also proposed a pressure responsive monitoring device for vacuum type electrical apparatus as a typical monitoring device for measuring pressure of vacuum of a vacuum circuit interrupter.

In a vacuum type electric device, it is required to monitor the pressure of the vacuum in order to maintain the superior characteristics of vacuum of which the dielectric strength make its use in power interrupting devices preferred over the use of special arc extinguishing materials, such as gases and liquids. Since vacuum offers a dielectric strength with a recovery rate of high voltage per microsecond, interruption can normally be anticipated at the first current zero in an A.C. current waveform. Further, a short gap between contacts can perform the interruption of current. Use of a short gap provides low mechanical shock.

Normally, the operating sequence of a vacuum circuit interrupter from a fault to clear may be accomplished in less than three cycles. Since energy dumped into a fault is proportional to time, the faster clearing action means less damage, lower contact erosion, longer maintenance free contact life, and maximum equipment protection. An important problem in vacuum type electrical devices is that the characteristics of the devices are affected by the pressure of vacuum. Namely, the problem with the use of vacuum circuit interrupters is that if there is a loss of vacuum as by leakage of air through a crack caused by undue mechanical stress, both the high dielectric strength of the vacuum and the rapid recovery are lost. The small contact spacing will no longer be able to sustain the high voltages. Arcs and flashovers will occur. The white arc will burn the electrode and melt the envelope, and may even extend into and attack other parts of the interrupter assembly.

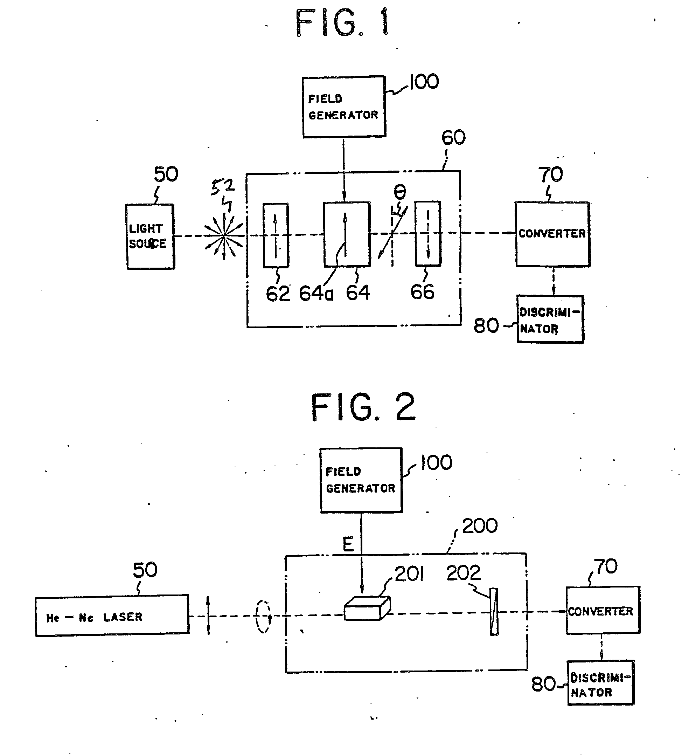

In recent years, various kinds of pressure measuring systems for vacuum type electric apparatus such as vacuum circuit interrupters have been put into practical use. One pressure measuring apparatus, a pressure responsive measuring device has been proposed by the present applicant. The pressure responsive measuring device employs an electric field detecting member for detecting the change of electric field strength of the vacuum type electric device corresponding to the change of vacuum pressure. The electric field detector of Figure 1 comprises an electric field generating member 100 to be tested, a light source 50 for generating light, an electric field detecting member 60 for detecting electric field and for converting variation of the electric field strength to optical energy variation responsive to the electric field strength, a photoelectric converting member 70 for converting optical energy to electrical energy supplied from the electric field detecting member and a discriminating circuit 80 outputting an electric signal.

The light source 50 is provided with a light emitting diode generating light in accordance with electric current flowing thereto. The electric field detecting member 60 is disposed on or in the vicinity of an electric field generating member. The electric field detecting member 60 is interconnected with the light source 50. The electric field detecting member 60 comprises a polarizer 62, an electric field sensitive element in the form of a Pockel's cell 64 and an analyzer 66. The Pockel's cell 64 is arranged between polarizer 62 and the analyzer 66. The analyzer 66 is connected to the photoelectric converting member 70. The vacuum pressure change discriminating member 80 is electrically connected to the photoelectric converting member 70, and an electrical output signal is employed as an alarm signal, an indicating signal and the like.

In the electric field detector of Figure 1, the light produced from the light source 50 is random polarized light 52. The random polarized light 52 is supplied to the electric field detecting member 60. In the electric field detecting member 60, the random light is polarized by the polarizer 62 to produce linearly polarized light of which an oscillating direction is shown by an arrow. The linearly polarized light is applied to the Pockel's cell 64. An electric signal in the form of electric field strength E is applied to the Pockel's cell 64 from the electric signal generating member 100. The Pockel's cell 64 causes the phase angle of polarization to change. The analyzer 66 is provided such that a plane of polarization is rectangular with respect to an optical axis. The electric field strength to be applied to the Pockel's cell 64 is decided by the electric field strength. The light from the Pockel's cell 64 is dependent upon the electric field strength E and is supplied to the analyzer 66.

In the electric field detector of the prior art, the Pockel's cell is, generally, made from a material which is made of a potassium dihydrogenphosphate $(KH_2PO_4)$ so called KDP or an ammonium dihydrogenphosphate $(NH_4H_2PO_4)$ so called ADP. Since the ADP and the KDP have great dielectric constant, ten times that of quartz, the electric field distribution is disturbed and thereby measuring deviation appears in measuring the electric field strength, furthermore ADP and KDP are deliquescent and expensive.

Quartz may be used as a Pockel's cell which has low dielectric constant. When quartz is used as the Pockel's cell, the correct measuring can be performed since the electric field distribution is not so disturbed, moreover quartz has constant light energy loss and has no deliquescence. Quartz has, however, natural double refraction in that the polarizing plane is rotated regardless of the electric field strength, when linearly polarized light is injected in to the quartz in an optical axis direction. Furthermore, quartz is inadequate to satisfy the accuracy and the reliability needed for an electric field detector, because the double refraction is dependent upon the thermal characteristics.

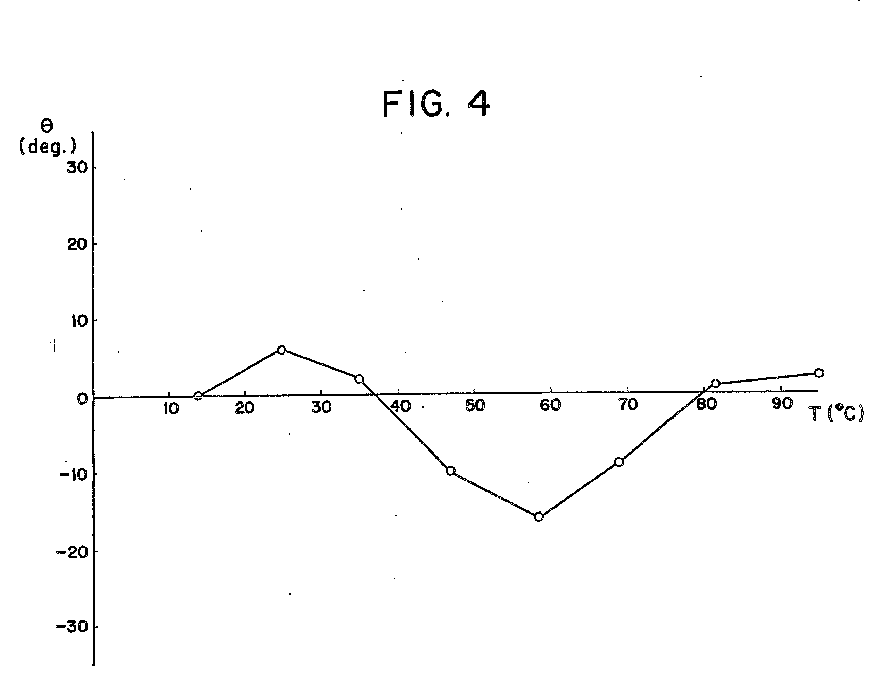

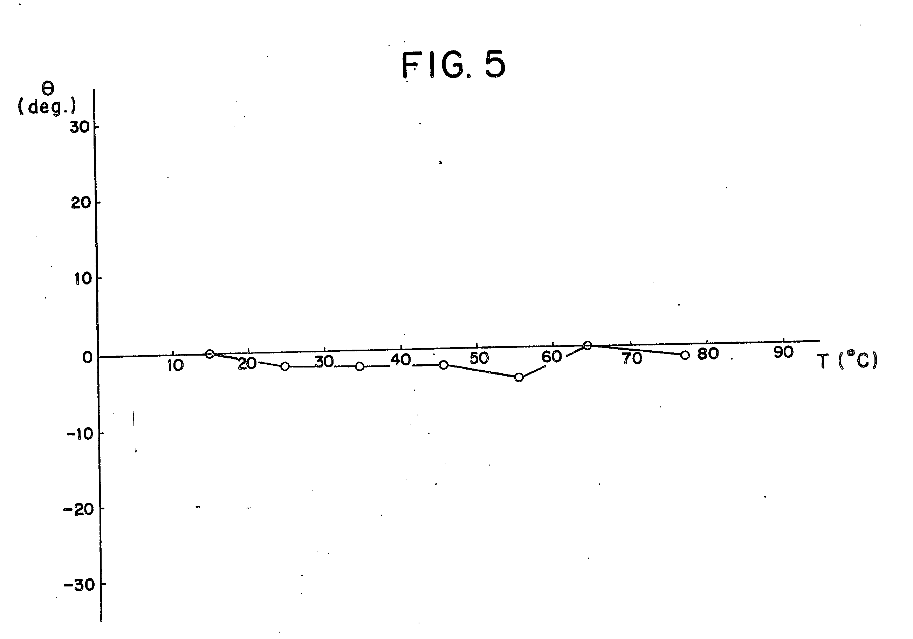

In order to avoid the defects of the quartz, the Pockel's cell can be made by coupling two quartz elements in series and in air-tight manner, each of which has symmetrical double refraction such that the natural double refraction is eliminated. The quartz is generally cut by 45°—Z cut and, therefore, the thermal characteristics of the polarizing plane are not good as Figures 4 and 5 show. In the Pockel's cell, phase difference of two specific oscillations of the polarizing plane is proportional to the electric field strength and the length of element of the optical path direction. Furthermore, it is difficult to manufacture the Pockel's cell, because high accuracy is required in order to adhere the two quartz in a manner such that an air layer is not formed therebetween and such that optical defects do not exist.

DE—A—2 341 074 discloses an electric detector comprising a light source for generating light, an electro-optical electric field detecting means arranged to receive light from the light source and to respond to change in the strength of an electric field, photoelectric converting means for converting an output light signal from said electric field detecting means to an electric signal, and discriminating means for indicating change of the electric field strength in response to the output of the photoelectric converting means, said electric field detecting means comprising an electric field sensitive element including a Pockel's cell arranged to change the phase difference of two specific oscillations of light.

It is an object of the present invention to provide an improved electric field detector for detecting electric field strength of an electrical machine.

It is a further object of the present invention to provide an electric field detector which operates highly reliably and with high performance.

It is an object of the present invention to provide an improved pressure responsive monitoring device for a vacuum type electric apparatus by means of using an electric field detector.

It is also an object of the present invention to provide a pressure responsive monitoring device for a vacuum type electric apparatus which operates highly reliably and with high performance.

The invention as claimed provides an electric field detector comprising: a light source for generating light, an electric field detecting means for detecting change of the strength of an electric field, a photoelectric converting means for converting an output light signal from said electric field detecting means to an electrical signal, a discriminating means for indicating changes in the electric field strength, said electric field detecting means being optically connected to both said light source and said photoelectric converting means, and said discriminating means being electrically connected to said photoelectric converting means, said electric field detecting means comprising a Pockel's cell made of a quartz crystal for transmitting linearly polarized light from said light source in said quartz crystal and for changing the phase difference between two specific oscillations in said quartz crystal, and an analyzing element for analyzing output light from said Pockel's cell, characterized in that the optical path of said linearly polarized light is a Z-direction or approximately a Z-direction of a crystallographic axis of said quartz crystal in said Pockel's cell and that said Pockel's cell has two surfaces for transmitting said linearly polarized light and said two surfaces are formed by cutting said quartz crystal in a vertical or an approximately vertical direction with respect to a Z-axis of said quartz crystal, and said Z-direction optical path is formed between said two surfaces.

Ways of carrying out the invention are described in detail below with reference to drawings which illustrate several specific embodiments.

In the accompanying drawings like parts in each of the several figures are identified by the same reference characters, and;

Figure 1 is a block diagram showing an electric field detector of the prior art.

Figure 2 is a block diagram showing an embodiment of an electric field detector of the present invention.

Figure 3A is a plan view of quartz for manufacturing a polarizing element employed in the present invention.

Figure 3B is a perspective view of the quartz of Figure 3A.

Figure 4 is a graph showing characteristics of quartz which is manufactured by 45°-cutting.

Figure 5 is a graph showing characteristics of two quartz elements coupled in series, each element being cut by a 45°-Z cut and having symmetrical characteristics.

Figure 6 is a graph showing characteristics of quartz used in the present invention.

Figure 7 is a sectional view of a vacuum circuit interrupter to be monitored by means employing an electric field detector of the present invention.

Figure 8 is an equivalent circuit diagram of the vacuum circuit interrupter of Figure 7.

Figure 9 is an equivalent circuit diagram of the vacuum circuit interrupter when its contacts are in open position.

Figure 10 is a characteristic diagram showing the relationship between the pressure of a vacuum circuit interrupter and electric field strength and electric potential appearing in the interrupter.

Figure 11 is a sectional view of an embodiment of an electric field detector employing a vacuum circuit interrupter as an electric field generating member.

Figure 12 is a block diagram of an embodiment of an electric field detector in accordance with the present invention.

Figure 13 is a characteristic diagram showing the relationship between the pressure of vacuum and output signals in the device of Figure 11.

Referring to Figure 2 of the drawings, there is shown an electric field detector of the present invention. The electric field detector comprises an electric field generating member 100 for generating an electric field and to be tested, a light source 50 for generating light and including a He-Ne laser lamp an electric field detecting member 200 for detecting electric field strength and for converting variation of the electric field strength to optical energy variation responsive to the electric field strength, and a photoelectric converting member 70 for converting optical energy to electrical energy supplied from the electric field detecting member 200.

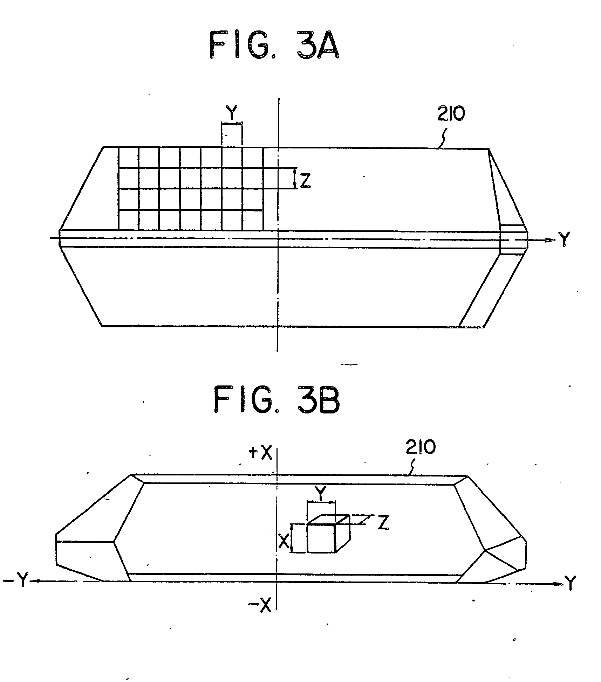

The electric field detecting member 200 comprises a Pockel's cell 201 which is manufactured by Z-cutting of a quartz element 210 shown in Figures 3A and 3B. As is shown in Figures 3A and 3B, the Pockel's cell 201 is manufactured by cutting the quartz 210 vertical direction or approximately vertical direction with respect to a Z-axis of the quartz 210 in order to avoid the piezo-electric phenomenon such that two parallel surfaces are formed by cutting the quartz 210 and an optical path in a Z-direction is formed between the two surfaces. Accordingly, the Pockel's cell 201 is constructed by cutting the quartz 21 such that the optical axis is along the Z-axis or approximately along the Z-axis of the Pockel's cell 201.

The operation of the electric field detector will be described by Figure 2 as follows.

The light produced from the light source is supplied to the electric field detecting member 200. In the electric field detecting member 200, the light is injected to the Pockel's cell 201 and an analyzer 202. An electric signal in the form of the electric field strength E is applied to the Pockel's cell 201 from the electric signal generating member 100. The Pockel's cell 201 causes the phase angle of polarization to change. The analyzer 202 is provided such that its plane of polarization is at right angles with respect to the optical polarizing direction. The light signal from the Pockel's cell 201 is dependent upon the applied electric field strength E and is supplied to the analyzer 202.

Figure 4 shows characteristics of quartz manufactured by the 45°-Z cut. As is shown in Figure 4, fluctuation of the rotation angle of the polarizing plane is great with respect to the temperature. Figure 5 shows characteristics of a Pockel's cell made by coupling two quartz elements in series in an air-tight manner, each element being cut by a 45°-Z cut. As Figure 5 shows the fluctuating component of such a cell is relatively small such as about 3%. As previously described, it is, however, difficult to manufacture such a Pockel's cell because high performance is required in adhering the two quartz elements in order to avoid formation of an air layer and optical defects.

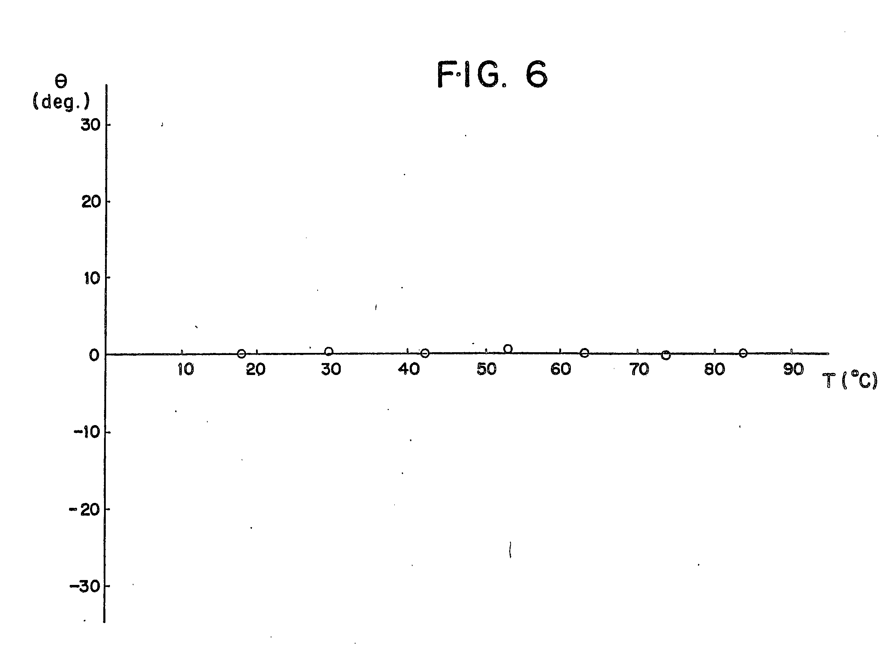

In accordance with the electric field detector of the present invention, the fluctuation responsive to the temperature of the polarizing plane is extremely small, as is shown in Figure 6. Figure 6 shows thermal characteristics of the fluctuation of the polarizing plane of quartz which is manufactured by Z-cutting or approximately Z-cutting in measuring when the quartz is inserted into the thermal oven. As seen from Figure 6, the fluctuation of the polarizing plane depending to the temperature is within a scope of the measuring error and is approximately zero. Accordingly, the output of the discriminating member 70 accurately corresponds to the change of the electric field strength E and, therefore, high performance and high reliable electric field detector can be obtained. Furthermore, the electric field detector is made compact, since only one element of Z-cut or approximately Z-cut quartz is employed as the Pockel's cell. Additionally, a light source producing random polarized light and a polariser can be used instead of the laser lamp.

According to the electric field detector described above, the transmission light quantity of the analyzer corresponds accurately to the electric field strength since the fluctuation of the polarizing plane of the Z-cut quartz is approximately zero against the change of the temperature, and thereby the magnitude of the electric field can be accurately detected by means of the transmission light quantity.

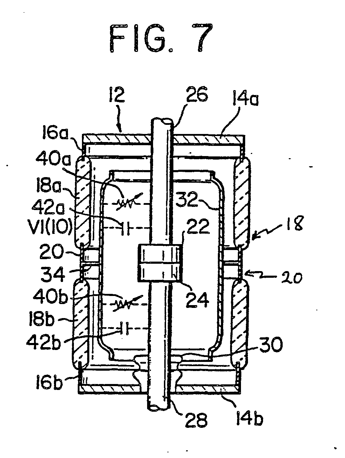

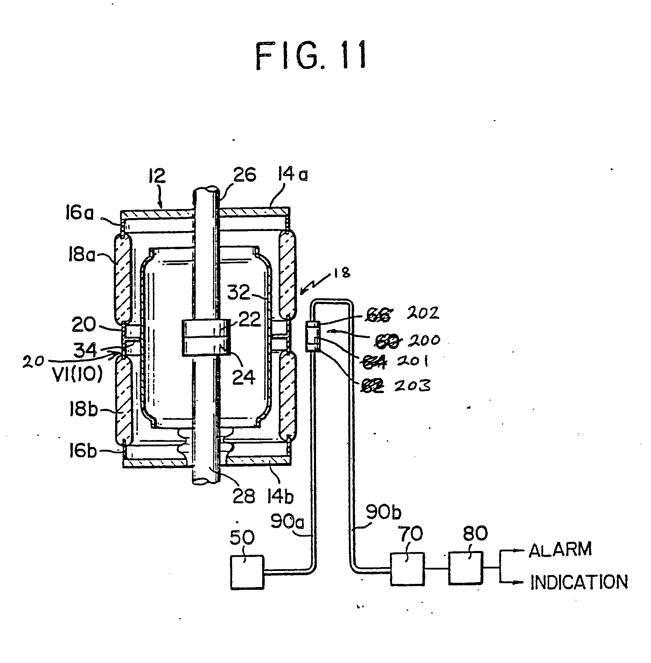

Figures 7 to 13 shown an electric field detector employing an electric device of vacuum type as an electric field generating member. Particularly, the electric field detector shown in Figure 11 is used as a pressure responsive monitoring device for vacuum interupter. Referring to Figure 7 of the drawings, there is shown an electric device of vacuum type in the form of a vacuum interrupting unit VI. The vacuum interrupting unit VI (10) comprises a highly evacuated envelope 12. This envelope 12 comprises a tubular insulating housing 18 and a pair of metallic end caps 14a and 14b located at opposite ends of the insulating housing 18. The end caps 14a and 14b are joined to the insulating housing 18 by vacuum tight seals in the form of metallic tubes 16a and 16b.

The insulating housing 18 comprises two tubular insulating sections 18a and 18b made of suitable glass or ceramics and two metallic tubes 20, 16a (16b) are connected hermetically in the tubular section 18a (18b). It should be noted that the number of the sections is not restricted to two, other embodiments of the present invention may have a different number. The tubular insulating sections are disposed colinearly and are joined together by a metallic disc 34 and two tubes 20, 20 hermetic seals between the insulating sections.

Disposed within the envelope 12 are two contacts movable relative to each other, shown in their fully contacted position. An upper contact 22 is a stationary contact, and a lower contact 24 is a movable contact. The stationary contact is suitably brazed to the lower end of a conductive supporting rod 26, which is integrally joined at its upper end to the metallic end plate 14a. The movable contact 24 is suitably brazed to the upper end of a conductive operative rod 28, which is vertically movable to effect opening and closing of the interrupter.

For permitting vertical motion of the operating rod 28 without impairing the vacuum inside the envelope 12, a suitable bellows 30 is provided around the operating rod 28. A tubular main shield 32 surrounds the contacts 22, 24 and protects each inner surface of the insulating sections 18a, 18b from being bombarded by arcing products.

The interrupter can be operated by driving the movable contact 24 upward and downward to close and open the electric power line. When the contacts are engaged, electric current can flow between opposite ends of the interrupter via the path the operating rod 28, the movable contact 24, the stationary contact 22 and the stationary supporting rod 26.

Circuit interruption is effected by driving the contact 24 downward from the closed contacts position by suitable operating means (not shown in the drawings). This downward motion establishes an arc between contacts. Assuming an alternating electric current circuit, the arc persists until about the time a natural electric current zero is reached, at which time the arc extinguishes and is thereafter prevented from reigniting by the high dielectric strength of the vacuum. A typical arc is formed during the circuit interrupting operation. For protecting the insulating housing 18 from the metallic vapors, the main shield 32 is supported on the tubular insulating housing by means of an annular metallic disc 34. This disc 34 is hermetically joined at its outer periphery to the central metallic tubes 20, 20 and at its inner periphery to the shield 32. The shield is in turn coupled to the electrodes 22, 24 and rods 26, 28 by leakage resistance 40a and 40b and stray capacitance 42a and 42b.

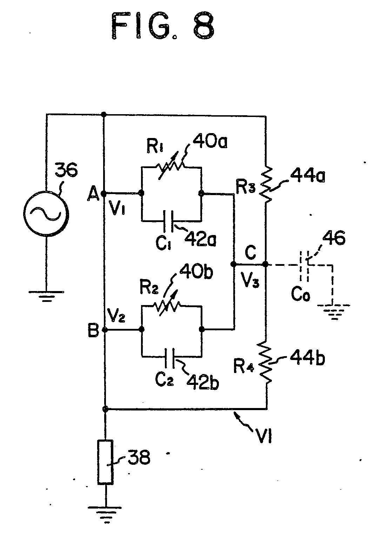

The vacuum circuit interrupter shown in Figure 7 is represented equivalently by a diagram shown in Figure 8. In the diagram of Figure 8, an electric power supply 36 is interrupted or opened by the vacuum interrupting unit VI. A variable resistor 40a shows leakage resistance between the stationary contact 22 (including the supporting rod 26) and the main shield 32. The capacitor 42a illustrates stray capacitance between the stationary contact 22 (including the supporting rod 26) and the shield 32. The variable resistor 40b represents leakage resistance existing between the movable contact 24 (including the operating rod 28) and the shield 32, and the capacitor 42b is also corresponded to stray capacitance between the movable contact 24 (including the operating rod 28) and the shield 32. Insulating sections 18a and 18b are, respectively, represented by the resistor 44a and the resistor 44b. The interrupter VI is generally connected between the electric power supply 36 and a load 38 in order to interrupt an electric load current supplied from the power supply 36 to the load 38. Stray capacitance between the main shield 32 joined to the metallic tubes 20, 20 and the ground is schematically shown at a capacitor 46.

Assuming that the electric potential difference between the stationary contact 22 and the main shield 32 is $V_1$, and the electric potential difference between the movable contact 24 and the main shield 32 is $V_2$, the electric potential difference $V_3$ between the shield 32 and the ground is changed by voltage drop between points A or B and a point C. Namely, the voltage drop between the point A or B and the point C depends upon a resultant reactance component of the variable resistors 40a and 40b and capacitors 42a and 42b and an electric current component which flows between the point A or B and the point C by way of the variable resistors 40a and 40b and the capacitors 42a and 42b. It will be appreciated that the resultant reactance component depends upon pressure of vacuum of the envelope 12 shown in Figure 7. In this case, capacitance values of the capacitors 42a and 42b are constant in spite of change of the pressure of vacuum and resistance values of the variable resistors 40a and 40b are, on the other hand, varied in accordance with the pressure of vacuum inside envelope 12. Under normal operating condition the electric potential at the point C is maintained constant. When the pressure of vacuum due to leakage or generation of metallic vapor is increased ions and charged particles are formed in the envelope 12. By the formation of ions and charged particles, the electric leakage current flows between the contacts 22 and 24 and the shield 32 because of the change in leakage resistance. Accordingly, by the loss of vacuum the electric leakage current flows from the contacts 22 and 24 to the ground by way of the variable resistors 40a, 40b, and the stray capacitance 46. By the flow of the leakage current, the electric potential difference $V_3$ changes in accordance with the pressure of vacuum inside envelope 12. On the other hand, capacitance values $C_1$ and $C_2$ are approximately constant in spite of the pressure change of vacuum, because specific dielectric constant of capacitance is almost equal at all pressures of vacuum change of the envelope 12.

It will be obvious that the potential difference $V_2$ of the movable contact 24 is equal to the electric potential difference $V_1$ of the stationary contact 22, when the contacts are closed position. Accordingly, the electric potential difference $V_3$ of the metallic shield connected to the metallic tubes 20, 20 changes in accordance with the leakage resistance values between contact 22 or 24 and the shield 32. Moreover, the electric potential difference $V_3$ at the tubes 20, 20 is changed by the capacitance value of the stray capacitance 46 between the main shield 32 and the ground.

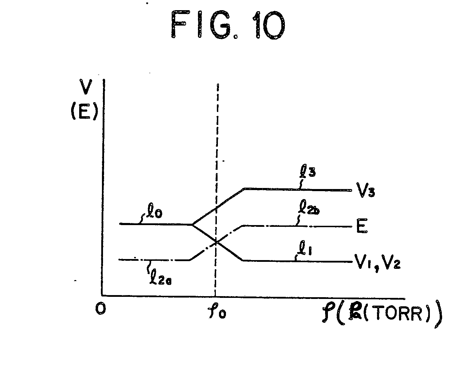

The inside of the envelope 12 is usually maintained highly evacuated at 13.33 µPa ($10^{-7}$ Torr) to 13.33µPa ($10^{-4}$ Torr). When the vacuum interrupter has the proper vacuum pressure, the electric potential at the main shield 32 is maintained constant, as is shown by the experimented data of Figure 10. In the data shown in Figure 10, a curve $l_0$ shows the electric potential difference $V_1$, $V_2$ and $V_3$ when the vacuum interrupter has the proper vacuum. A curve $l_1$ shows the electric potential difference $V_1$ and $V_2$ when the pressure of vacuum is increased. Further, the curves $l_{2a}$ and $l_{2b}$ are illustrative of electric field strength of position spaced apart from the vacuum circuit interrupter in the vicinity of the tubular main shield 32.

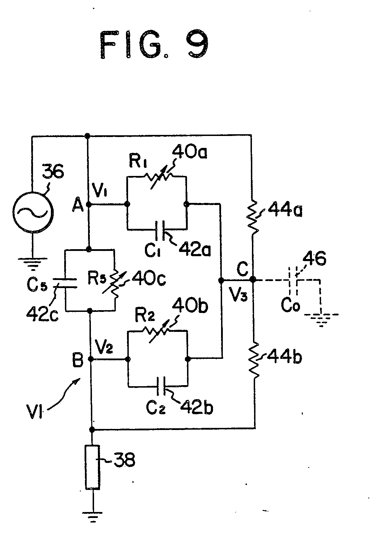

Figure 9 shows an equivalent diagram of the vacuum interrupting unit VI when the contacts 22 and 24 are opened position. In Figure 9, a variable resistor 40C represents leakage resistance between the stationary contact 22 and the movable contact 24, and a capacitor 42c also represents stray capacitance between the stationary contact 22 and the movable contact 24. The leakage resistance between contacts also varies in accordance with the pressure of vacuum of the envelope 12. Accordingly, it will be apparent that the electric potential difference $V_3$ at the tubular main shield 32 varies responsive to the pressure of vacuum of the envelope 12 as in Figure 8, because the electric potential difference of each portions of the interrupter changes in accordance with the leakage current inside the envelope 12.

Referring now particularly to Figure 11, the electric field detector for vacuum circuit interrupter is shown in greater detail. The electric field detector 200 comprises an electric field generating member in the form of a vacuum circuit interrupter to be tested, a light source 50 for generating light, an electric field detecting member 200 for detecting electric field and for converting variation of the electric field strength to optical energy variation responsive to the electric field strength, a photoelectric converting member 70 for converting optical energy to electrical energy supplied from the electric field detecting member, and a vacuum pressure change discriminating circuit 80 for discriminating the vacuum pressure change and outputting an electrical signal.

In more detail, the light source is provided with a light emitting diode generating light in accordance with electric current flowing thereto. The electric field detecting member 200 is disposed on or in the vicinity of an electric field generating member in the form of the vacuum circuit interrupter having the main shield 32. The electric field detecting member 200 is interconnected with the light source 50 by a light guide tube in the form of an optical fiber 90a. The electric field detecting member 200 comprises a polarizer 203, an electric field sensitive element in the form of a Pockel's cell 201 made of Z-cut quartz or approximately Z-cut quartz and an analyzer 202. The polarizer 203 is connected to the light source 50 by the optical fiber 90a. The Pockel's cell 201 is arranged to be located between polarizer 203 and the analyzer 202. The analyzer 202 is connected to the photo-electric converting member 70 by a light guiding tube in the form of an optical fiber 90a. The vacuum pressure change discriminating member 80 is electrically connected to the photo-electric converting member 70, and an electrical output signal is employed as an alarm signal, an indicating signal and the like.

The operation of the pressure responsive monitoring device will be described by means of Figures 11, 12 and 13 as follows.

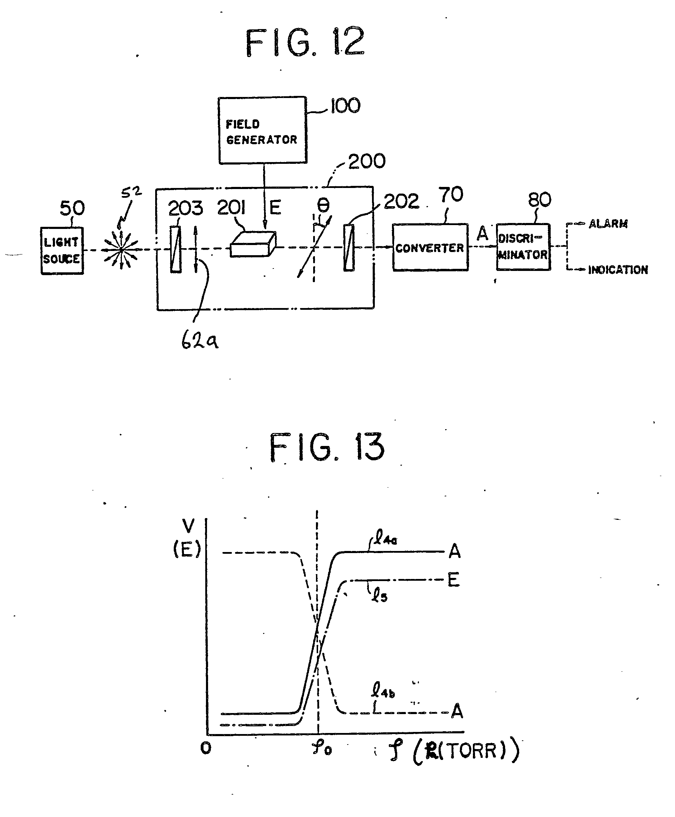

As is shown in Figure 12, the light produced from the light source 50 is random polarized light 52. The random polarized light 52 is supplied to the electric field detecting member 200 by way of the optical fiber 90a. In the electric field detecting member 200, the random light 52 is polarized by the polarizer 203 to produce linearly polarized light of which an oscillating direction is shown by an arrow 62a. The linearly polarized light is applied to the Pockel's cell 201 made of Z-cut quartz or approximately Z-cut quartz. An electrical signal in the form of electric field strength E is applied to the Pockel's cell 201 from the electric signal generating member 100 in the form of the vacuum circuit interrupter VI. The Pockel's cell 201 causes the phase angle of polarization to change. The analyzer 202 is provided such that its plane of polarization is at right angles or approximately at right angles with respect to the optical axis. The electric field strength to be applied to the Pockel's cell 201 is decided by the pressure change of vacuum of the interrupter. The light from the Pockel's cell 201 is dependent upon the applied electric field strength E and is supplied to the analyzer 202.

When the pressure of vacuum is proper, the electric field strength E is low, as is shown by a curve $l_{4a}$ of Figure 13 and, on the other hand, the electric field strength E becomes high when the pressure of vacuum increases. A phase angle θ of the plane of polarization changes in accordance with the applied electric field strength change which corresponds to the pressure change of vacuum of the vacuum interrupting unit VI. Deviation of the angle θ is set so as to be zero when the pressure of vacuum is proper, and becomes large, when the vacuum is lost. Consequently, the quantity of light is high in case of the loss of vacuum and, therefore, output signal A of the discriminating member 80 become great, as is shown by a curve $l_{4a}$ of Figure 13. Additionally, a curve $l_{4b}$ shown in Figure 13 is a characteristic of the output of the discriminating member 80 when the analyzer 202 is provided such that the plane of polarization becomes parallel relationship with respect to that of the polarizer 203.

The vacuum pressure change discriminating member 80 activates in accordance with the output signal A of the photo-electric converting member 70 to indicate the loss of vacuum.

Although the loss of vacuum is detected by means of sensing the variation of the electric potential difference in the vicinity of the tubular main shield in the monitoring device described above, it is possible to detect the loss of vacuum, by sensing the variation of the electric field strength in other portions of the envelope of the vacuum circuit interrupter. Moreover, it is appreciated that other electrical devices of the general type to be monitored can be used.

According to the monitoring device of the above embodiment, the pressure change of vacuum can be monitored in non-contacting condition without changing the construction of the vacuum circuit interrupter. Since the insulation between the vacuum circuit interrupter corresponding to a high voltage portion and the electric field detecting member can be easily performed, monitoring of the pressure change of vacuum can be performed in all voltage ranges of the interrupter.

Since a high voltage portion in the form of the interrupting unit VI is isolated from a low voltage portion such as a measuring circuit by light coupler, it is easy to monitor operation. Since the electric field detecting member is constructed by an insulating material such as an analyzer, a Pockel's cell made of Z-cut quartz or approximately Z-cut quartz and a polarizer and the like, high reliability is obtained. The detection of the pressure change of vacuum is performed by the optical device, and thereby the high performance monitoring device can be obtained because the device is free from an electric noise.

Moreover, according to the embodiment described above, the vacuum pressure detector element is located in the electric field generating portion of the vacuum circuit interrupter, the vacuum pressure change within the envelope is detected by means of the optical device. With this arrangement the change of the electric field due to the change of vacuum pressure can be applied to the electric field detecting member. Therefore, the electric field detecting member converts the electric field strength to the quantity of light energy. The quantity of light energy is converted to the electric energy quantity by means of the photo-electric converting means.

## Claims

1. An electric field detector comprising:
a light source (50) for generating light,
an electric field detecting means (200) for detecting change of the strength of an electric field,
a photoelectric converting means (70) for converting an output light signal from said electric field detecting means (200) to an electrical signal,
a discriminating means (80) for indicating changes in the electric field strength,
said electric field detecting means (200) being optically connected to both said light source (50) and said photoelectric converting means (70), and said discriminating means (80) being electrically connected to said photoelectric converting means (70),
said electric field detecting means (200) comprising a Pockel's cell (201) made of a quartz crystal (210) for transmitting linearly polarized light from said light source (50) in said quartz crystal (201, 210) and for changing the phase difference between two specific oscillations in said quartz crystal (201, 210), and
an analyzing element (202) for analyzing output light from said Pockel's cell (201), characterized in that
the optical path of said linearly polarized light is a Z-direction or approximately a Z-direction of a crystallographic axis of said quartz crystal (210) in said Pockel's cell (201) and that said Pockel's cell (201) has two surfaces for transmitting said linearly polarized light and said two surfaces are formed by cutting said quartz crystal (210) in a vertical or an approximately vertical direction with respect to a Z-axis of said quartz crystal (210), and said Z-direction optical path is formed between said two surfaces.

2. An electric field detector as claimed in claim 1, in combination with a vacuum circuit interrupter (10), the electric field detecting means (200) being arranged to respond to change in the strength of the electric field of the vacuum circuit interrupter (10).

3. An electric field detector as claimed in claim 2, wherein said discriminating means (80) comprises a vacuum pressure change discriminating member (80) for indicating changes in the vacuum pressure within an envelope (12) of the vacuum circuit interrupter (10) in response to the electrical signal from said photoelectric converting means (70).

4. An electric field detector as claimed in claim 1 wherein said electric field detecting means (200) further comprises a polarizing means (203) for polarizing the light from said light source (50), and the Pockel's cell (201) is operative to change the angle of polarization of light polarized by said polarizing means (203).

5. An electric field detector as claimed in claim 2 wherein said Pockel's cell (201) of the electric field detecting means (200) is separated from a part of the envelope (12) of the vacuum circuit interrupter (10) by a predetermined distance, the electric field strength being responsive to changes in the vacuum pressure inside the envelope (12).

6. An electric field detector as claimed in claim 5 wherein said vacuum circuit interrupter (10) of the electric field generating means (100) further comprises a pair of separable contacts (22, 24) within said envelope (12) arranged to be connected in series with an electric power circuit (36), a metal shield (32) surrounding the contacts (22, 24) and shielding the envelope (12, 18) against metal deposits, tubular flanges (20) and a disk (34) for supporting said metal shield (32).

7. An electric field detector as claimed in claim 6 wherein said electric field detecting means (200) is separated from said metal shield (32) by a predetermined distance.

8. An electric field detector as claimed in claim 4, wherein said polarizing means (203) of said electric field detecting means (200) is connected to the light source (50) by an optical fiber (90a).

9. An electric field detector as claimed in claim 1 wherein said photoelectric converting means (70) is connected to said analyzing element (202) by an optical fiber (90b).

**Patentansprüche**

1. Detektor für elektrische Felder mit:
einer Lichtquelle (50) zur Erzeugung von Licht, einem Detektormittel (200) für elektrisches Feld, zur Erfassung einer Änderung der Stärke eines elektrischen Feldes,
einem photoelektrischen Wandlermittel (70) zum Wandeln eines Ausgangs-Lichtsignals von dem Detektormittel (200) für elektrisches Feld in ein elektrisches Signal, einem Diskriminatormittel (80) zur Anzeige von Änderungen in der elektrischen Feldstärke,
wobei das Detektormittel (200) für elektrisches Feld optisch sowohl mit der Lichtquelle (50) als auch dem photoelektrischen Wandlermittel (70) verbunden ist und das Diskriminatormittel (80) elektrisch mit dem photoelektrischen Wandlermittel (70) verbunden ist, wobei das Detektormittel (200) für elektrisches Feld eine Pockels-Zelle (201) aus einem Quarzkristall (210) enthält zum Aussenden linear polarisierten Lichtes von der Lichtquelle (50) in dem Quarzkristall (201, 210) und zum Ändern der Phasendifferenz wischen zwei bestimmten Schwingungen in dem Quarzkristall (201, 210), und
einem Analysatorelement (202) zum Analysieren von Ausgangslicht von der Pockels-Zelle (201), dadurch gekennzeichnet, daß der optische Weg des linear polarisierten Lichtes eine Z-Richtung oder annähernd eine Z-Richtung einer kristallographischen Achse des Quarzkristalls (210) in der Pockels-Zelle (201) ist und daß die Pockels-Zelle (201) zwei Flächen zum Aussenden des linear polarisierten Lichtes besitzt und die zwei Flächen durch Schneiden des Quarzkristalls (210) in einer vertikalen oder einer annähernd vertikalen Richtung bezüglich einer Z-Achse des Quarzkristalles (201) gebildet sind, und daß der optische Weg in Z-Richtung zwischen den zwei Flächen gebildet ist.

2. Detektor für elektrische Felder nach Anspruch 1, in Kombination mit einem Vakuum-Schalter (10), wobei das Detektormittel (200) für elektrisches Feld angeordnet ist zur Reakton auf Änderungen in der Stärke des elektrischen Feldes des Vakuum-Schalters (10).

3. Detektor für elektrische Felder nach Anspruch 2, bei dem das Diskriminatormittel (80) ein Unterdruckänderungs-Diskriminatormittel (80) zum Anzeigen von Änderungen des Unterdrucks innerhalb eines Gehäuses (12) des Vakuum-Schalters (10) in Abhängigkeit von dem elektrischen Signal von dem photoelektrischen Wandlermittel (70) ist.

4. Detektor für elektrische Felder nach Anspruch 1, bei dem das Detektormittel (200) für elektrisches Feld weiter ein Polarisationsmittel (203) zum Polarisieren des Lichtes von der Lichtquelle (50) umfaßt, und die Pockels-Zelle (201) zur Änderung des Polarisationswinkels des durch das Polarisationsmittel (203) polarisierten Lichtes wirksam ist.

5. Detektor für elektrische Felder nach Anspruch 2, bei dem die Pockels-Zelle (201) des Detektormittels (200) für elektrisches Feld von einem Teil des Gehäuses (12) des Vakuum-Schalters (10) mit einem vorbestimmten Abstand getrennt ist, und die elektrische Feldstärke auf Änderungen des Unterdruckes innerhalb des Gehäuses (12) reagiert.

6. Detektor für elektrische Felder nach Anspruch 5, wobei der Vakuum-Schalter (10) des Erzeugungsmittels (100) für elektrisches Feld weiter zwei trennbare Kontakte (22, 24) innerhalb des Gehäuses (12) umfaßt, die angeordnet sind, in Reihe mit einem elektrischen Leistungskreis (36) angeschlossen zu werden, einen die Kontakte (22, 24) umgebenden Metallschirm (32), der das Gehäuse (12, 18) vor Metallablagerungen abschirmt, rohrförmige Flansche (20) und eine Scheibe (34) zum Abstützen des Metallschirmes (32).

7. Detektor für elektrische Felder nach Anspruch 6, bei dem das Detektormittel (200) für elektrisches Feld von dem Metallschirm (32) mit einem vorbestimmten Abstand getrennt ist.

8. Detektor für elektrische Felder nach Anspruch 4, bei dem das Polarisationsmittel (203) des Detektormittels (200) für elektrisches Feld mit der Lichtquelle (50) durch eine optische Faser (90a) verbunden ist.

9. Detektor für elektrische Felder nach Anspruch 1, bei dem das photoelektrische Wandlermittel (70) mit dem Analysatorelement (202) durch eine optische Faser (90b) verbunden ist.

**Revendications**

1. Détecteur de champ électrique, comportant: une source lumineuse (50) qui produit de la lumière, un dispositif (200) détecteur de champ électrique destiné à détecter une variation de l'intensité d'un champ électrique, un dispositif (70) de conversion photoélectrique destiné à convertir un signal lumineux de sortie dudit dispositif (200) de détection de champ électrique en un signal électrique, un dispositif discriminateur (80) destiné à indiquer des variations de l'intensité du champ électrique, ledit dispositif (200) détecteur de champ électrique étant couplé optiquement avec ladite source lumineuse (50) et ledit dispositif de conversion photoélectrique (70), et ledit dispositf de discrimination (80) étant connecté électriquement audit dispositif de conversion photoélectrique (70), ledit dispositif (200) détecteur de champ électrique comprenant une cellule de Pockel (201) faite d'un cristal de quartz (210) pour transmettre de la lumière de polarisation linéaire provenant de ladite source lumineuse (50) dans ledit cristal de quartz (201, 210) et pour changer le déphasage entre deux oscillations spécifiques dans ledit cristal de quartz (201, 210) et un élément analyseur (202) destiné à analyser la lumière de sortie de ladite cellule de Pockel (201), caractérisé en ce que le trajet optique de ladite lumière de polarisation linéaire est une direction Z ou à peu près une direction Z d'un axe cristallographique dudit cristal de quartz (210) dans ladite cellule de Pockel (201) et en ce que ladite cellule de Pockel (201) comporte deux surfaces pour transmettre ladite lumière de polarisation linéaire et lesdites deux surfaces étant formées en coupant ledit cristal de quartz (210) dans une direction verticale ou à peu près verticale par rapport à l'axe Z dudit cristal de quartz (210), et ledit trajet optique de direction Z étant formé entre lesdites deux surfaces.

2. Détecteur de champ électrique selon la revendication 1, en combinaison avec un coupe-circuit sous vide (10), le dispositif (200) de détection de champ électrique étant agencé pour réagir à des variations de l'intensité du champ électrique dans le coupe-circuit sous vide (10).

3. Détecteur de champ électrique selon la revendication 2, dans lequel ledit dispositif de discrimination (80) consiste en un élément (80) de discrimination de variation de pression de vide pour indiquer des variations de la pression de vide dans une enveloppe (12) du coupe-circuit sous vide (10) en réponse au signal électrique provenant dudit dispositif (70) de conversion photoélectrique.

4. Détecteur de champ électrique selon la revendication 1, dans lequel ledit dispositif (200) de détection de champ électrique comporte en outre un dispositif de polarisation (203) destiné à polariser la lumière provenant de ladite source lumineuse (50) et la cellule de Pockel (201) ayant pour effet de changer.l'angle de polarisation de la lumière polarisée par ledit dispositif de polarisation (203).

5. Détecteur de champ électrique selon la revendication 2, dans lequel ladite cellule de Pockel (201) du dispositif (200) de détection de champ électrique est séparée d'une partie de l'enveloppe (12) du coupe-circuit sous vide (10) d'une distance prédéterminée, l'intensité du champ électrique réagissant à des variations de la pression de vide à l'intérieur de l'enveloppe (12).

6. Détecteur de champ électrique selon la revendication 5, dans lequel ledit coupe-circuit sous vide (10) du dispositif générateur de champ électrique (100) comporte en outre deux contacts séparables (22, 24) dans ladite enveloppe (12), agencés pour être connectés en série par un circuit d'alimentation électrique (36), un écran métallique (32) entourant les contacts (22, 24) et protégeant l'enveloppe (12, 18) contre des dépôts métalliques, des rebords métalliques (20) et un disque (34) pour supporter ledit écran métallique (32).

7. Détecteur de champ électrique selon la revendication 6, dans lequel ledit dispositif (200) de détection de champ électrique est séparé de l'écran métallique (32) par une distance prédéterminée.

8. Détecteur de champ électrique selon la revendication 4, dans lequel ledit dispositif de polarisation (203) dudit dispositif (200) de détection de champ électrique est connecté à la source lumineuse (50) par une fibre optique (90a).

9. Détecteur de champ électrique selon la revendication 1, dans lequel ledit dispositif (70) de. conversion photoélectrique est connecté audit élément analyseur (202) par une fibre optique (90b).

# FIG. 1

# FIG. 2

# FIG. 3A

# FIG. 3B

# FIG. 4

0 067 683

FIG. 5

# FIG. 6

0 067 683

FIG. 7

# FIG. 8

# FIG. 9

# FIG. 10

# FIG. 11

# FIG. 12

# FIG. 13